(19) **Europäisches Patentamt**

**European Patent Office**

**Office européen des brevets**

(11) Veröffentlichungsnummer: **0 246 689 B1**

## (12) EUROPÄISCHE PATENTSCHRIFT

(45) Veröffentlichungstag der Patentschrift: **05.08.92**

(51) Int. Cl.⁵: **H03M 5/16**

(21) Anmeldenummer: **87200843.8**

(22) Anmeldetag: **11.05.87**

(54) Schaltung zum Umsetzen von Drei-Zustands-Signalen in binäre Signale.

(30) Priorität: **17.05.86 DE 3616818**

(43) Veröffentlichungstag der Anmeldung:
**25.11.87 Patentblatt 87/48**

(45) Bekanntmachung des Hinweises auf die
Patenterteilung:
**05.08.92 Patentblatt 92/32**

(84) Benannte Vertragsstaaten:
**DE FR GB IT NL**

(56) Entgegenhaltungen:
**DE-B- 2 840 006**
**FR-A- 2 102 970**

**Valvo GmbH, Hamburg:**
**"Schaltungssammlung", Heft 2, Ausgabe**
**Juni 1972, Seite 122**

**E. HöLZLER, H. HOLZWARTH, "Pulstechnik -**
**Band II - Anwendungen und Systeme",**
**Springer Verlag, Berlin Heidelberg New York,**
**1976; Seiten 144 und 145**

(73) Patentinhaber: **Philips Patentverwaltung**
**GmbH**
**Wendenstrasse 35 Postfach 10 51 49**
**W-2000 Hamburg 1(DE)**

(84) Benannte Vertragsstaaten:
**DE**

(73) Patentinhaber: **N.V. Philips' Gloeilampenfa-**
**brieken**
**Groenewoudseweg 1**
**NL-5621 BA Eindhoven(NL)**

(84) Benannte Vertragsstaaten:
**FR GB IT NL**

(72) Erfinder: **Martiny,Ingo**
**Wildacker 52**
**W-2000 Hamburg 54(DE)**

(74) Vertreter: **Hartmann, Heinrich, Dipl.-Ing. et al**
**Philips Patentverwaltung GmbH Wenden-**
**strasse 35 Postfach 10 51 49**
**W-2000 Hamburg 1(DE)**

EP 0 246 689 B1

## Beschreibung

Die Erfindung bezieht sich auf eine Schaltungsanordnung zum Umsetzen von Drei-Zustands-Signalen in binäre Signale. Bei bekannten Schaltungen dieser Art wird mittels eines oder mehrerer ohmscher Spannungsteiler ein Referenz-Spannungsbereich definiert, der zwischen dem Potential der positiven und der negativen Versorgungsspannungsquelle liegt.

Wenn der Stromverbrauch einer solchen Schaltung gering sein soll, müssen hochohmige Spannungsteiler verwendet werden, die sich schlecht in integrierter Schaltungstechnik herstellen lassen.

Aufgabe der vorliegenden Erfindung ist es, eine Schaltungsanordnung der eingangs genannten Art ohne ohmsche Spannungsteiler zu schaffen.

Diese Aufgabe wird erfindungsgemäß dadurch gelöst, daß eine erste einseitig mit dem negativen Versorgungsspannungsanschluß und eine zweite einseitig mit dem positiven Versorgungsspannungsanschluß einer Versorgungsspannungsquelle verbundene Gleichstromquelle vorgesehen ist und daß die Gleichstromquellen mit ihrem freien Anschluß über eine erste bzw. eine zweite Diodenstrecke mit einem gemeinsamen Eingang und über eine dritte bzw. vierte Diodenstrecke, die zur ersten bzw. zweiten Diodenstrecke gleichartig sind, mit einem ersten bzw. einem zweiten ein Ausgangssignal liefernden Ausgangstransistor verbunden sind.

Die Diodenstrecken können dabei aus einem oder mehrere in Serie und in Durchlaßrichtung geschalteten Diodenelementen bestehen. Wenn das Potential am gemeinsamen Eingang positiv ist, fließt der Strom der ersten Stromquelle über die erste Diodenstrecke zum gemeinsamen Eingang und dem mit der dritten Diodenstrecke gekoppelten Ausgangstransistor wird kein Strom zugeführt. Hingegen fließt der Strom der zweiten Stromquelle in diesem Fall über die vierte Diodenstrecke zu dem damit gekoppelten Ausgangstransistor.

Wird hingegen das Potential am gemeinsamen Eingang genügend negativ, dann fließt der Strom der zweiten Stromquelle über die zweite Diodenstrecke zum gemeinsamen Eingang. Die vierte Diodenstrecke bleibt stromlos und dem damit gekoppelten Ausgangstransistor wird kein Strom zugeführt. Dafür fließt der von der ersten Stromquelle gelieferte Strom über die dritte Diodenstrecke zu dem damit gekoppelten Ausgangstransistor.

In einem Zwischenbereich fließt der Strom der beiden Stromquellen nur über die dritte und die vierte Diodenstrecke zu den beiden Ausgangstransistoren.

Es sei an dieser Stelle erwähnt, daß aus der "Schaltungssammlung" der Firma Valvo, Heft 2, Ausgabe 1972, Seite 122 sowie aus dem Buch von Hölzler und Holzwarth "Pulstechnik - Band II - Anwendungen und Systeme", Springer-Verlag, Berlin Heidelberg New York, 1976, Seiten 144 und 145 an sich DTL-Inverter bekannt sind, bei denen ein über einen Widerstand fließender Gleichstrom je nach der Spannung am Eingang des Inverters entweder über eine Diodenstrecke zum Eingang oder über eine weitere Diodenstrecke in einen Ausgangstransistor fließt. Die bekannten Inverter können aber nur ein Zwei-Zustand-Signal in ein (dazu komplementäres) binäres Ausgangssignal umsetzen.

Wenn die dritte bzw. die vierte Diodenstrecke der erfindungsgemäßen Schaltung direkt mit dem Eingang, z.B. der Basis des zugehörigen Ausgangstransistors, verbunden sind, müssen diese Transistoren den entgegengesetzten Leitfähigkeitstyp aufweisen und mit entgegengesetzten Versorgungsspannungsklemmen verbunden sein. Die an ihren Ausgängen, insbesondere ihren Kollektoren, auftretenden Potentiale, die die binären Ausgangssignale darstellen, würden dann von der Höhe der Versorgungsspannung abhängig sein. Dies läßt sich nach einer Weiterbildung der Erfindung dadurch vermeiden, daß von der dritten und vierten Diodenstrecke die eine direkt und die andere über einen Stromspiegel mit dem ersten bzw. zweiten Ausgangstransistor verbunden ist und daß die beiden Ausgangstransistoren gleichartig geschaltet sind. Die Ausgangstransistoren können dann vom gleichen Leitfähigkeitstyp und mit der gleichen Versorgungsspannungsklemme verbunden sein.

Wenn über die dritte bzw. die vierte Diodenstrecke kein Strom fließt, wird den Basen der Ausgangstransistoren von den Stromquellen kein Strom zugeführt, so daß sie gesperrt sind. Um eine sichere Sperrung zu erreichen und einen definierten Übergang vom leitenden in den gesperrten Zustand, ist in der Weiterbildung der Erfindung vorgesehen, daß dem Eingang wenigstens eines der Ausgangstransistoren ein Schalttransistor parallelgeschaltet ist, der durch den Ausgangsstrom eines Stromspiegels steuerbar ist, dessen Eingangsstrom der über die erste bzw. die zweite Diodenstrecke fliessende Strom ist. Der Eingang eines Ausgangstransistor wird dabei durch den parallelgeschalteten Schalttransistor kurzgeschlossen, so daß etwaige Restströme vom Ausgangstransistor ferngehalten werden.

Eine bevorzugte Weiterbildung der Erfindung sieht vor, daß die in der Schaltung enthaltenen Transistoren, deren Emitter mit dem negativen Versorgungsspannungsanschluß verbunden sind, in $I^2L$-Schaltungstechnik ausgebildet sind und daß der Basisstrom dieser Transistoren von einem gemeinsamen Injektor geliefert wird. Bei dieser Ausgestaltung kann bei Herstellung der Schaltung in integrierter Schaltungstechnik Kristallfläche eingespart werden und die Ströme der Stromquellen, die von

dem Injektor geliefert werden, können relativ klein sein.

Die Erfindung wird nachstehend anhand der Zeichnung näher erläutert. Es zeigen:

Fig. 1
ein vereinfachtes Prinzipschaltbild einer erfindungsgemäßen Schaltung,

Fig. 2a und 2b
den Verlauf der Ströme der Ausgangstransistoren als Funktion der Eingangsspannung, und

Fig. 3
das Schaltbild einer bevorzugten Ausführungsform nach der Erfindung.

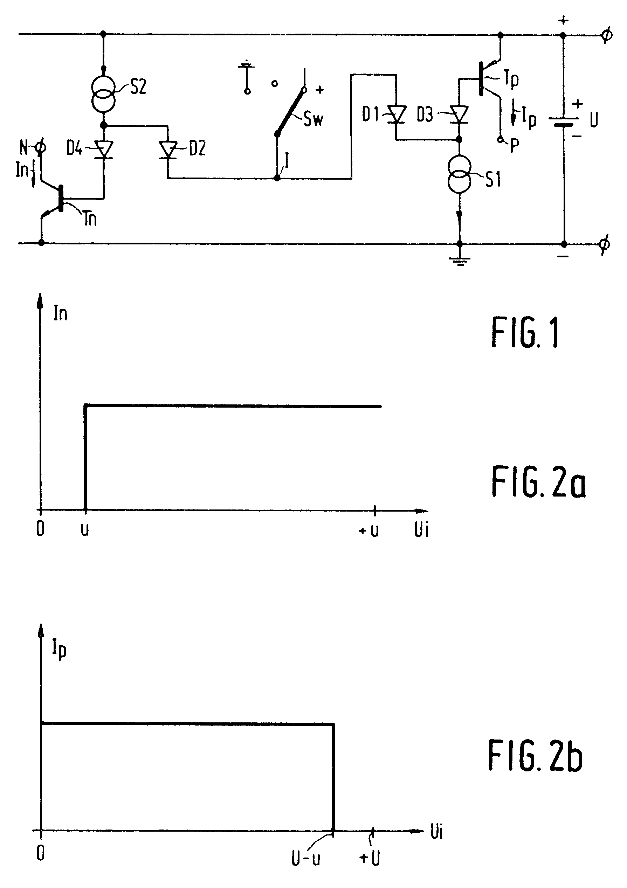

Die Fig. 1 enthält eine erste Gleichstromquelle S1, die mit ihrem einen Anschluß an die negative, mit Masse verbundene Versorgungsspannungsklemme und eine zweite Gleichstromquelle S2, die mit ihrem einen Anschluß an die positive Versorgungsspannungsklemme einer Versorgungsspannungsquelle U angeschlossen ist. Der jeweils andere Anschluß der ersten bzw. der zweiten Gleichstromquelle, die einen Gleichstrom von z.B. 1 $\mu$A liefern, ist über eine erste bzw. eine zweite Diodenstrecke D1 bzw. D2 mit einem gemeinsamen Eingang verbunden, an dem das umzusetzende Drei-Zustands-Signal anliegt. Der freie Anschluß der Stromquellen S1 bzw. S2 ist darüber hinaus über eine dritte Diodenstrecke D3, die mit der ersten Diodenstrecke D1 gleichartig ist, bzw. über eine vierte Diodenstrecke, die mit der zweiten Diodenstrecke gleichartig ist, mit dem Basisanschluß eines pnp-Ausgangstransistors Tp bzw. eines npn-Ausgangstransistors Tn verbunden, dessen Emitter mit der positiven bzw. negativen Versorgungsspannungsklemme verbunden ist und dessen Kollektor den Ausgang P bzw. N der Schaltung bildet. An die Ausgänge P und N ist eine nicht näher dargestellte Auswerteschaltung, vorzugsweise in I²L-Schaltungstechnik angeschlossen, die die an diesen Signalen auftretenden binären Ausgangssignale verarbeitet.

Der gemeinsame Eingang I ist an einen Schalter Sw mit drei Schaltkontakten angeschlossen, so daß je nach Stellung des Schalters der gemeinsame Eingang entweder unbeschaltet ist oder mit Masse oder der positiven Speisespannung verbunden ist.

In den Fig. 2a und 2b ist der Verlauf der Ausgangsströme In und Ip der Ausgangstransistoren Tn und Tp als Funktion der Spannung Ui am gemeinsamen Eingang I angegeben. Wenn die Spannung am gemeinsamen Eingang Null Volt beträgt oder zumindest kleiner ist als die Emitter-Basis-Spannung u des Transistors Tn, dann ist die Vorspannung der Diodenstrecke D2 in Flußrichtung größer als die entsprechende Vorspannung der Diodenstrecke D4. Deshalb fließt praktisch der gesamte Strom der Stromquelle S2 über die Diodenstrecke D2 zum Eingang I. Der Transistor Tn erhält keinen Basisstrom, so daß der Strom In am Ausgang N praktisch Null ist. - Auf der anderen Seite ist - bei Massepotential am Eingang I - die Diodenstrecke D3 leitend und die Diodenstrecke D1 gesperrt. Der gesamte Strom der Stromquelle S1 fließt also über die Diodenstrecke D3 in die Basis des Transistors Tp, so daß am Ausgang P ein Strom Ip fließt, nämlich der Kollektorstrom des Transistors Tp.

An dem beschriebenen Zustand ändert sich nichts, solange die Spannung an dem Eingang I unterhalb der Basis-Emitter-Spannung des Transistors Tn bleibt.

Wenn die Spannung an dem Eingang I die Basis-Emitter-Spannung u des Transistors Tn überschreitet, wird die Vorspannung der Diodenstrecke D4 in Flußrichtung größer als die entsprechende Spannung an der Diodenstrecke D2. Der Strom der Stromquelle S2 fließt dann in die Basis des Transistors Tn und als Folge erscheint am Ausgang N ein Strom In - der Kollektorstrom des Transistors Tn. Der Ausgangstransistor Tp bleibt unverändert leitend, solange nur das Potential am Eingang I negativer bleibt als das Basispotential des Ausgangstransistor Tp.

In diesem Zustand führen also beide Ausgangstransistoren einen Ausgangsstrom. Das gleiche gilt auch, wenn der Eingang I unbeschaltet bleibt, weil dann kein Strom über den Eingang I fließen kann. Auch ein Stromfluß von der Stromquelle S2 über die Diodenstrecken D2 und D1 zur Stromquelle S1 ist ausgeschlossen, wenn die Versorgungsspannung U größer ist als die Summe aus der Basis-Emitter-Spannung eines Ausgangstransistors, aus der Vorwärtsspannung einer der Diodenstrecken D3 oder D4 und aus der Betriebsspannung der Stromquelle S1 oder S2.

Wenn die Spannung Ui am Eingang I positiver wird als die Spannung an der Basis des Transistors Tp (gegenüber Masse), dann fließt der Strom der Stromquelle S1 über die Diodenstrecke D1 und der Ausgangstransistor Tp wird stromlos, d.h. der Ausgangsstrom Ip wird Null. - Der Strom der Stromquelle S2 fließt in diesem Zustand weiterhin über die Diodenstrecke D4 in den Eingang des Transistors Tn, so daß ein Ausgangsstrom In fließt; über die Diodenstrecke D2 fließt kein Strom.

Ein Drei-Zustands-Signal am Eingang I wird durch die in Fig. 1 dargestellte Schaltung also wie folgt in ein binäres Signal an den Ausgängen N und P umgesetzt:

a) Im Eingangs-Spannungsbereich O < Ui < u führt der Ausgangstransistor Tn keinen Ausgangsstrom und der Ausgangstransistor Tp führt Strom.

b) Im Eingangs-Spannungsbereich u < Ui < U-u bzw. bei unbeschaltetem Eingang führen beide Ausgangstransistoren einen Ausgangsstrom.

c) Im Eingangs-Spannungsbereich U-u < Ui < U führt der Ausgangstransistor Tn einen Ausgangsstrom und führt der Ausgangstransistor Tp keinen Ausgangsstrom.

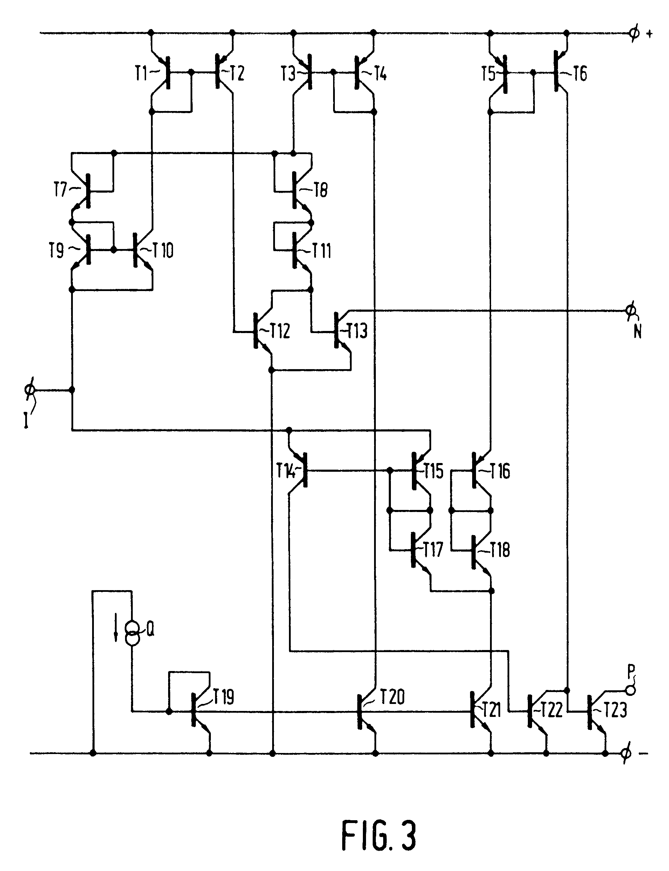

In Fig. 3 ist eine bevorzugte Ausführungsform der Erfindung dargestellt.

Die erste Stromquelle S1 wird dabei durch die Kollektor-Emitter-Strecke eines npn-Transistors T21 gebildet, dessen Emitter mit der negativen Versorgungsspannungsklemme verbunden ist und dessen Kollektor mit der ersten bzw. der dritten Diodenstrecke verbunden ist. Die erste Diodenstrecke wird durch die Serienschaltung eines durch Verbindung seines Kollektors mit seiner Basis als Diode wirksamen npn-Transistors T17 und eines ebenfalls als Diode geschalteten pnp-Transistors T15 gebildet. Die dritte Diodenstrecke ist gleichartig aufgebaut und besteht aus der Serienschaltung der als Dioden geschalteten npn- bzw. pnp-Transistoren T18 und T16.

Die Stromquelle S2 wird durch die Kollektor-Emitter-Strecke eines Transistors T3 gebildet, dessen Emitter mit der positiven Versorgungsspannungsklemme und dessen Kollektor mit der zweiten bzw. der vierten Diodenstrecke verbunden ist. Die zweite Diodenstrecke wird durch die als Diode geschalteten npn-Transistoren T7 und T9 und die vierte Diodenstrecke durch die als Diode geschalteten Transistoren T8 und T11 gebildet.

Ein Transistor T13, dessen Basis über die vierte Diodenstrecke T8, T11 mit der zweiten Stromquelle T3 verbunden ist und dessen Emitter an Masse angeschlossen ist, entspricht in seiner Funktion dem Ausganstransistor Tn. Die dritte Diodenstrecke ist hingegen nicht direkt mit der Basis des npn-Ausgangstransistors T23 verbunden, dessen Emitter an die negative Versorgungsspannungsklemme angeschlossen ist, sondern mit dem Eingang eines durch die Transistoren T5 und T6 gebildeten Stromspiegels, dessen Ausgang mit der Basis des Transistors T23 verbunden ist. Die Einschaltung des Stromspiegels T5, T6 hat den Vorteil, daß als Ausgangstransistoren Transistoren gleichen Leitfähigkeitstyps verwendet werden können.

Die erste Stromquelle T21 wird durch einen Ausgang eines Stromspiegels gebildet, dessen Eingang ein als Diode geschalteter npn-Transistor T19 ist und dessen anderer Ausgang ein Transistor T20 ist, dessen Basis-Emitter-Strecke der Basis-Emitter-Strecke des Transistors T21 parallelgeschaltet ist. Der Kollektor des Transistors T20 ist mit einem als Diode geschalteten pnp-Transistor T4 verbunden, dessen Emitter mit der positiven Versorgungsspannungsklemme verbunden ist und der zusammen mit dem Transistor T3 einen Stromspiegel bildet. Deshalb ist der Strom der Stromquelle T3 genauso groß wie der Strom der Stromquelle T21. Der Eingangsstrom des Stromspiegels T19, T20, T21 wird von einer Stromquelle Q geliefert und hat eine Größe von z.B. 1 $\mu$A.

Um ein sicheres Sperren der Ausgangstransistoren T13 bzw. T23 zu erreichen, ist den Basis-Emitter-Strecken dieser Transistoren die Kollektor-Emitter-Strecke eines Transistors T12 bzw. T22 parallelgeschaltet. Der Transistor T12 wird von dem Ausgang eines Stromspiegels T1, T2 gespeist, dessen Eingang mit dem Ausgang eines weiteren Stromspiegels verbunden ist, der einen Transistor T10 und den als Diode geschalteten Transistor T9, der zu der zweiten Diodenstrecke gehört, umfaßt. Der Transistor T22 wird vom Kollektorstrom eines Transistors T14 gesteuert, der zusammen mit dem als Diode geschalteten Transistor T15 der ersten Diodenstrecke einen Stromspiegel bildet. Sobald ein hinreichender Strom über die erste Diodenstrecke T15, T17 bzw. die zweite Diodenstrecke T7, T9 fließt, liefert der Ausgang des zugehörigen Stromspiegels einen Strom, der den Transistor T22 bzw. T12 leitend macht und den Eingang des Ausgangstransistors T13 bzw. T23 kurzschließt.

Mit Vorteil sind die npn-Transistoren T12, T13 und T19...T23, deren Emitter mit der negativen Versorgungsspannungsklemme bzw. Masse verbunden ist, in I$^2$L-Schaltungstechnik ausgeführt. Die Stromquelle Q kann dann durch einen sogenannten Injektor-Transistor gebildet werden, der bei geringer Kristallfläche geeignet ist genügend kleine Ströme zu erzeugen, insbesondere wenn er noch zur Versorgung von I$^2$L-Gattern benutzt wird, die Teil einer weiteren Schaltung ist, die mit der in Fig. 3 dargestellten Schaltung auf dem gleichen Halbleitersubstrat angebracht ist.

Die Versorgungsspannung der in Fig. 3 dargestellten Schaltung braucht lediglich das Dreifache der Basis-Emitter-Spannung eines der Transistoren zuzüglich der Kollektor-Emitter-Sättigungsspannung zu betragen; wenn die als Diode geschalteten Transistoren T7, T8 und T17, T18 weggelassen werden, kann die Versorgungsspannung sogar noch um eine Basis-Emitter-Spannung niedriger sein und die Schaltung bei sonst unveränderten Eigenschaften noch einfacher sein.

Die Schaltung kann nicht nur stationäre Signale verarbeiten, wie sie der Schaltung Sw in Fig. 1 liefert, sondern auch Wechselspannungssignale.

**Patentansprüche**

1. Schaltungsanordnung zum Umsetzen von Drei-Zustands-Signalen in binäre Signale, dadurch gekennzeichnet, daß eine erste einseitig mit dem negativen Versorgungsspannungsanschluß und eine zweite einseitig mit dem positiven Versorgungsspannungsanschluß einer Versorgungsspannungsquelle verbundene Gleichstromquelle (S1 bzw. S2; T21 bzw. T3) vorgesehen ist und daß die Gleichstromquellen mit ihrem freien Anschluß über eine erste bzw. eine zweite Diodenstrecke (D1 bzw. D2; T15, T17 bzw. T7, T9) mit einem gemeinsamen Eingang (I) und über eine dritte bzw. vierte Diodenstrecke (D3 bzw. D4; T16, T18 bzw. 78, T11), die zur ersten bzw. zweiten Diodenstrecke gleichartig sind, mit einem ersten bzw. einem zweiten ein Ausgangssignal (Ip bzw. In) liefernden Ausgangstransistor (Tp bzw. Tn; T23 bzw. T13) verbunden sind.

**2.** Schaltungsanordnung nach Anspruch 1, dadurch gekennzeichnet, daß von der dritten (T16, T18) und der vierten Diodenstrecke (T8, T11) die eine direkt und die andere über einen Stromspiegel (T5, T6) mit dem ersten bzw. zweiten Ausgangstransistor (T23 bzw. T13) verbunden ist und daß die beiden Ausgangstransistoren gleichartig geschaltet sind.

**3.** Schaltungsanordnung nach Anspruch 1 oder 2, dadurch gekennzeichnet, daß dem Eingang wenigstens eines der Ausgangstransistoren ein Schalttransistor (T22 bzw. T12) parallelgeschaltet ist, der durch den Ausgangsstrom eines Stromspiegels (T14, T15 bzw. T9, T10) steuerbar ist, dessen Eingangsstrom der über die erste bzw. die zweite Diodenstrecke (T15, T17 bzw. T9, T10) fliessende Strom ist.

**4.** Schaltungsanordnung nach Anspruch 3, dadurch gekennzeichnet, daß die erste bzw. zweite Diodenstrecke den Eingang eines Stromspiegels bildet, dessen Ausgang direkt oder über einen weiteren Stromspiegel (T1, T2) mit dem Steuereingang des Schaltransistors (T22 bzw. T12) verbunden ist.

**5.** Schaltungsanordnung nach einem der vorhergehenden Ansprüche, dadurch gekennzeichnet, daß die erste Stromquelle (T21) durch den Ausgang eines ersten Stromspiegels (T19 bzw. T20, T21) gebildet wird und daß die zweite Stromquelle (T3) durch den Ausgang eines zweiten Stromspiegels (T4, T3) gebildet wird, dessen Eingang (T4) mit einem Ausgang T20) des ersten Stromspiegels gekoppelt ist.

**6.** Schaltungsanordnung nach einem der vorhergehenden Ansprüche, dadurch gekennzeichnet, daß die in der Schaltung enthaltenen Transistoren (T12, T13, T19...T23), deren Emitter mit dem negativen Versorgungsspannungsanschluß verbunden sind, in $I^2L$-Schaltungstechnik ausgebildet sind

und daß der Basisstrom dieser Transistoren von einem gemeinsamen Injektor geliefert wird.

## Claims

**1.** A circuit arrangement for converting tri-state signals into binary signals, characterized in that there are provided a first direct current source which is unilaterally connected to the negative supply voltage terminal and a second direct current source which is unilaterally connected to the positive supply voltage terminal of a supply voltage source (S1 and S2, respectively; T21 and T3, respectively), the respective free terminals of the direct current sources being connected to a common input (I) via a first and a second diode path, respectively (D1 and D2, respectively; T15 and T17, and T7 and T9, respectively), and, via a third and a fourth diode path (D3 and D4, respectively; T16 and T18, and T8 and T11, respectively) which are similar to the first and the second diode path, respectively, to a first and a second output transistor, respectively, (Tp and Tn, respectively; T23 and T13, respectively) which supply an output signal (Ip and In, respectively).

**2.** A circuit arrangement as claimed in Claim 1, characterized in that of the third (T16, T18) and the fourth diode path (T8, T11) one is connected directly to the first or the second output transistor, respectively (T23 and T13, respectively), the other one being connected thereto via a current mirror (T5, T6), the two output transistors being connected in the same sense.

**3.** A circuit arrangement as claimed in Claim 1 or 2, characterized in that a switching transistor (T22 and T12, respectively) is connected parallel to the input of at least one of the output transistors and can be controlled by the output current of a current mirror (T14, T15 and T9, T10, respectively), whose input current is the current flowing via the first or the second diode path (T15, T17 and T9, T7, respectively), respectively.

**4.** A circuit arrangement as claimed in Claim 3, characterized in that the first or the second diode paths forms the input of a current mirror whose output is connected to the control input of the switching transistor (T22 and T12, respectively) either directly or via a further current mirror (T1, T2).

**5.** A circuit arrangement as claimed in any one of the preceding Claims, characterized in that the first current source (T21) is formed by the output of a first current mirror (T19, T20, T21), the second current source (T3) being formed by the output of a second current mirror (T4, T3) whose input (T4) is coupled to an output (T20) of the first current mirror.

6. A circuit arrangement as claimed in any one of the preceding Claims, characterized in that the transistors (T12, T13, T19...T23) which are included in the circuit and whose emitters are connected to the negative supply voltage terminal are constructed by means of the $I^2L$ technique, the base current of these transistors being supplied by a common injector.

**Revendications**

1. Circuit pour convertir des signaux à trois états en signaux binaires, caractérisé en ce qu'il est prévu une première source de courant continu (S1; T21) reliée d'un côté à la borne d'alimentation négative d'une source d'alimentation, ainsi qu'une deuxième source de courant continu (S2; T3) reliée d'un côté à la borne d'alimentation positive d'une source d'alimentation et en ce que, par leur borne libre, les sources de courant continu sont reliées à travers de premier ou deuxième trajets de diode (D1 ou D2; T15, T17 ou T7, T9) à une entrée commune (I) et, à travers un troisième ou un quatrième trajet de diode (D3 ou D4; T16, T18 ou T8, T11), analogue au premier ou au deuxième trajet de diode, à des premier ou deuxième transistors de sortie (Tp ou Tn; T23 ou T13), fournissant un signal de sortie (Ip ou In).

2. Circuit selon la revendication 1, caractérisé en ce que, les troisième (T16, T18) et quatrième (T8, T11) trajets de diode sont reliés, l'un directement et l'autre par l'intermédiaire d'un miroir de courant (T5, T6), au premier ou au deuxième transistor de sortie (T23, T13) et en ce que les deux transistors de sortie sont connectés de manière analogue.

3. Circuit selon la revendication 1 ou 2, caractérisé en ce qu'un transistor de commutation (T22 ou T12) est monté en parallèle avec l'entrée d'au moins l'un des transistors de sortie, transistor de commutation pouvant être commandé par le courant de sortie d'un miroir de courant (T14, T15 ou T9, T10), miroir de courant dont le courant d'entrée est le courant qui circule par le premier ou le deuxième trajet de diode (T15, T17 ou T9, T10).

4. Circuit selon la revendication 3, caractérisé en ce que le premier ou le deuxième trajet de diode forme l'entrée d'un miroir de courant dont la sortie est reliée directement ou par l'intermédiaire d'un autre miroir de courant (T1, T2) à l'entrée de commande du transistor de commutation (T22 ou T12).

5. Circuit selon l'une quelconque des revendications précédentes, caractérisé en ce que la première source de courant (T21) est formée par la sortie d'un premier miroir de courant (T19 ou T20, T21) et en ce que la deuxième source de courant (T3) est formée par la sortie d'un deuxième miroir de courant (T4, T3) dont l'entrée (T4) est couplée à une sortie (T20) du premier miroir de courant.

6. Circuit selon l'une quelconque des revendications précédentes, caractérisé en ce que les transistors compris dans le circuit (T12, T13, T19 ... T23), et dont les émetteurs sont reliés à la borne d'alimentation négative, sont réalisés selon la technique de montage $I^2L$ et en ce que le courant de base de ces transistors est fourni par un injecteur commun.

FIG.1

FIG.2a

FIG.2b

FIG. 3